(19) **Europäisches Patentamt / European Patent Office / Office européen des brevets**

(11) **EP 1 643 004 B1**

(12) **EUROPEAN PATENT SPECIFICATION**

(45) Date of publication and mention
of the grant of the patent:
**06.04.2011 Bulletin 2011/14**

(21) Application number: **04732754.9**

(22) Date of filing: **13.05.2004**

(51) Int Cl.:
*C23C 16/44* (2006.01)    *H01L 21/285* (2006.01)

(86) International application number:
**PCT/JP2004/006445**

(87) International publication number:
**WO 2004/101845 (25.11.2004 Gazette 2004/48)**

(54) **TREATING DEVICE USING RAW MATERIAL GAS AND REACTIVE GAS**

BEHANDLUNGSVORRICHTUNG MIT VERWENDUNG VON AUSGANGSSTOFFGAS UND
REAKTIVEM GAS

DISPOSITIF DE TRAITEMENT FAISANT APPEL A DU GAZ BRUT ET A DU GAZ REACTIF

(84) Designated Contracting States:
**DE FR GB IT NL**

(30) Priority: **13.05.2003 JP 2003134991**
**02.09.2003 JP 2003310713**

(43) Date of publication of application:
**05.04.2006 Bulletin 2006/14**

(60) Divisional application:
**08004931.5 / 1 942 206**

(73) Proprietor: **TOKYO ELECTRON LIMITED**
**Minato-ku**
**Tokyo 107-8481 (JP)**

(72) Inventors:
• **TANAKA, Masayuki,**
**Tokyo Electron AT Limited**
**Nirasaki-shi,**
**Yamanashi 4070192 (JP)**
• **KAI, Kouzo,**
**Tokyo Electron Limited**
**Fuchu-shi Tokyo 1838705 (JP)**

• **MURAKAMI, Seishi,**
**Tokyo Electron AT Limited**
**Nirasaki-shi,**
**Yamanashi 407-8511 (JP)**
• **MIYASHITA, Tetsuya,**
**Tokyo Electron AT Limited**
**Nirasaki-shi,**
**Yamana-shi 407-511 (JP)**

(74) Representative: **Liesegang, Eva**
**Forrester & Boehmert**
**Pettenkoferstrasse 20-22**
**80336 München (DE)**

(56) References cited:
EP-A1- 0 409 603      WO-A2-2004/017368
JP-A- 5 109 621       JP-A- 6 089 873
JP-A- 7 094 425       JP-A- 7 206 586
JP-A- 2002 053 963    JP-A- 2002 164 348
JP-A- 2002 339 071    US-A- 5 554 226
US-A- 6 133 148       US-B1- 6 277 201
US-B1- 6 461 436

**Description**

BACKGROUND OF THE INVENTION

Field of the Invention

The present invention relates to a processing apparatus that performs a film-deposition process for, e.g., a semiconductor wafer, by using a source gas and a reactive gas (such as a reducing gas and an oxidizing gas).

Background Art

In a manufacturing process of a semiconductor integrated circuit, an object to be processed such as a semiconductor wafer is generally, repeatedly subjected to various kinds of single-wafer processes, such as a film-deposition process, etching process, heat process, modification process, and crystallization process, so as to form a desired integrated circuit. In each of the various kinds of processes, a processing gas necessary for a certain process is introduced to a processing vessel. That is, a film-deposition gas is introduced to a processing vessel when a film-deposition process is performed. Similarly, an ozone gas is introduced for performing a modification processing, and an inert gas such as $N_2$ gas or $O_2$ gas is introduced for performing a crystallization process.

For example, in a single-wafer type processing apparatus which heat-treats semiconductor wafers one by one, a table incorporating, e.g., a resistance heater, is disposed in a processing vessel capable of forming a vacuum. A predetermined processing gas is fed into the vessel, with a semiconductor wafer being disposed on an upper surface of the table, so that the wafer is subjected to various kinds of heat processes under predetermined process conditions (for example, Japanese Patent Laid-Open Publication No. 2002-256440).

In this manufacturing process, in order to fill a recess of a wiring pattern, a recess between wiring patterns, and a recess such as a hole, metal such as W (tungsten), WSi (tungsten silicide), Ti (titanium), TiN (titanium nitride), TiSi (titanium silicide), Cu (copper), and $Ta_2O_5$ (tantalum oxide) or a metal compound is used to deposit a thin film in the recesses. Out of the various thin films, a tungsten film is especially employed, because of its small specific resistance and a low temperature required for forming a film. In order to form a tungsten film, $WF_6$ (hexafluoro tungsten) used as a source gas is reduced by hydrogen, silane, dichlorosilane or the like, so as to deposit a tungsten film.

In order to form an insulation film (dielectric film) of a good electric property, a source gas of a halogen metal compound such as $ZrCl_4$ or $ZrBr_4$, and a reactive gas such as ozone or $H_2O_2$ are used to deposit a high dielectric film (Japanese Patent Laid-Open Publication No. 2002-151489).

In accordance with a higher integration and miniaturization of a semiconductor integrated circuit, it is desired not only to reduce a film-thickness of each layer, but also to further reduce a line-width of a wiring pattern and a diameter of a hole such as a contact hole and a via hole.

Under these circumstances, Japanese Patent Laid-Open Publication No. 2002-151489, for example, discloses the following processing method, in which a film-thickness of a film deposited on a wafer is reduced, while maintaining a high intrafilm uniformity of the film-thickness and a high electric property of the deposited film. That is, a substrate holder incorporating a resistance heater is disposed in a processing vessel capable of forming a vacuum. A plurality of processing gases of different kinds, e.g., $ZrCl_4$ gas and ozone, are intermittently, alternately caused to flow in the processing vessel, so as to repeatedly deposit a $ZrO_2$ film of a thickness about a single molecular layer on a surface of a semiconductor wafer held on the substrate holder.

When a source gas such as $ZrCl_4$ and a reactive gas such as ozone are alternately, intermittently introduced to a processing vessel, a pre-flow operation for causing a gas to flow for only a few seconds must be carried out for each time immediately before a gas is actually supplied to the processing vessel. This is because the pre-flow operation stabilizes a gas flow rate so that a uniformity of a film-thickness or the like can be improved. A gas used for the pre-flow operation does not pass through the processing vessel, but bypasses the same to be directly discharged to a vacuum evacuating system.

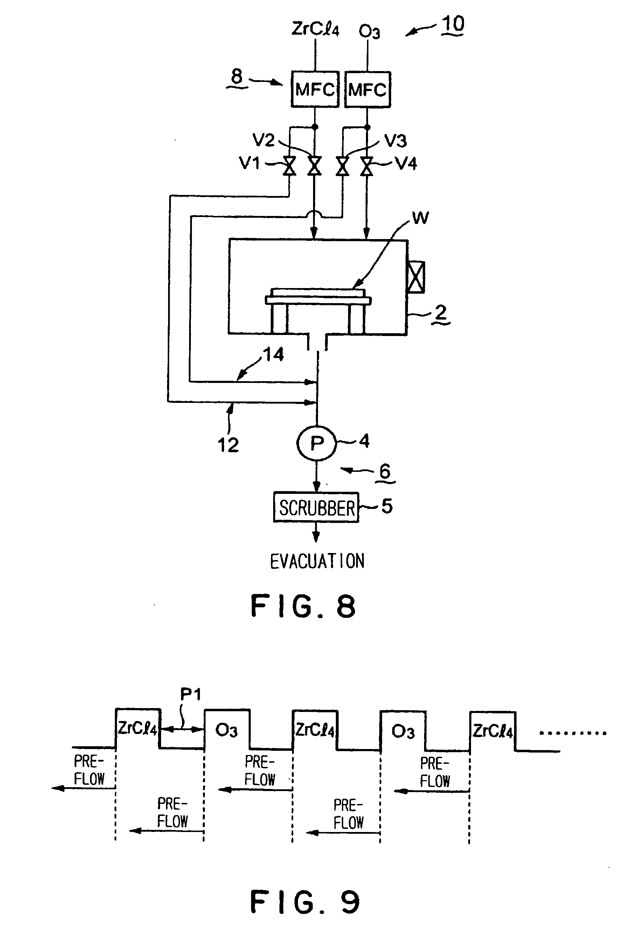

The above-described conventional constitution and procedure are briefly described with reference to Figs. 8 and 9. As shown in Fig. 8, an inside of a processing vessel 2 containing a semiconductor wafer W can be evacuated to form a vacuum by a vacuum evacuating system 6 provided with a vacuum pump 4. A source gas supply system 8 and a reactive gas supply system 10 are connected to the processing vessel 2. The source gas supply system 8 supplies, e.g., $ZrCl_4$ as a source gas, while the reactive gas supply system 10 supplies, e.g., ozone ($O_3$) as a reactive gas. A by-pass pipe 12 communicates the gas supply system 8 to the vacuum evacuating system 6, and a by-pass pipe 14 communicates the gas supply system 10 to the vacuum evacuating system 6. A scrubber 5 for burning a gas remaining in an evacuated gas to eliminate the same is disposed in the vacuum evacuating system 6.

The source gas supply system 8, the reactive gas supply system 10, and the by-pass pipes 12 and 14 are respectively provided with switching valves V1 to V4. By suitably opening and closing the respective switching valves V1 to V4, the $ZrCl_4$ gas and the $O_3$ gas whose flow rates are respectively controlled by respective mass flow controllers MFC are alternately, intermittently fed into the processing vessel 2, as shown in Fig. 9. In this manner, thin films are deposited on the wafer W one by one. During this process, a pre-flow operation is carried out for a few seconds, immediately before each gas is supplied on a pulse basis. A gas used for the pre-flow operation passes through the by-pass pipe 12 or 14 to be directly discharged to the vacuum evacuating system 6, without passing through the processing vessel 2.

As shown in Fig. 9, the gases are independently fed into the processing vessel 2. On the other hand, it repeatedly occurs that the gases simultaneously flow into the vacuum evacuating system 6 provided with the vacuum pump 4. Thus, the gases react to each other in the vacuum pump 4 to generate deposits. The deposits adhere to a rotational driving system in the vacuum pump 4, which may cause a damage in the vacuum pump 4. In particular, although the inside of the vacuum pump 4 is not raised to a process temperature of, e.g., about 410˚C, the temperature in the vacuum pump 4 is easily raised to a some degree, i.e., about 100˚C to 190˚C, by a gas compression. Thus, generation of deposits is further promoted.

In this case, when a supply interval (pulse interval) PI between the gas supply operations as shown in Fig. 9 is prolonged, it is possible to prevent the gases from mixing to react with each other. However, since this solution makes a process period so long as to deteriorate a throughput, it cannot be adopted. Alternatively, a trap device can be disposed in front of the vacuum pump 4. However, the trap device is space-consuming. In addition, since the trap device must be periodically exchanged to a new one, a maintenance operation is troublesome and requires a higher cost, resulting in deterioration in a throughput.

## SUMMARY OF THE INVENTION

In view of the foregoing context, the present invention has been made to effectively solve the problems. An object of the present invention is to provide a processing apparatus that does not allow a source gas and a reactive gas to simultaneously flow into a vacuum evacuating system, so that generation of unwanted deposits which may cause a malfunction of a vacuum pump can be prevented.

Another object of the present invention is to provide a processing apparatus that can restrain a maintenance frequency of a trap device for removing an impurity gas from an evacuated gas.

In order to accomplish the object, there is provided a processing apparatus comprising:

a processing vessel that contains therein an object to be processed;
a source gas supply system that selectively supplies a source gas into the processing vessel;
a reactive gas supply system that selectively supplies a reactive gas into the processing vessel;
a vacuum evacuating system having a vacuum pump, that evacuates an atmosphere in the processing vessel to form therein a vacuum;
a gas by-pass line connecting either one of the source gas supply system and the reactive gas supply system to the vacuum evacuating system, the gas by-pass line bypassing the processing vessel;
a gas buffer tank provided in the gas by-pass line, that temporarily stores therein a gas; and
an on-off valve disposed in the gas by-pass line between the gas buffer tank and the vacuum evacuating system.

According to the processing apparatus, a source gas and a reactive gas are not allowed to simultaneously flow into the vacuum pump of the vacuum evacuating system through the respective by-pass lines. Thus, it is possible to prevent in the vacuum evacuating system generation of deposits which may cause a malfunction of the vacuum pump. For the same reason, a trap device is no longer needed, which was needed in a conventional vacuum evacuating system.

It is preferable that the processing apparatus further comprises a gas supply controller that controls the source gas supply system, the reactive gas supply system and the on-off valve, such that the source gas and the reactive gas are not allowed to simultaneously flow into the vacuum evacuating system.

In order to accomplish the object, there is also provided a processing apparatus comprising:

a processing vessel that contains therein an object to be processed;
a source gas supply system that selectively supplies a source gas into the processing vessel;
a reactive gas supply system that selectively supplies a reactive gas into the processing vessel;
a vacuum evacuating system having a vacuum pump, that evacuates an atmosphere in the processing vessel to form therein a vacuum;
a source gas by-pass line connecting the source gas supply system to the vacuum evacuating system, the by-pass line bypassing the processing vessel;
a source gas buffer tank provided in the source gas by-pass line, that temporarily stores therein the source gas;
a first on-off valve disposed in the source gas by-pass line between the source gas buffer tank and the vacuum evacuating system;

a reactive gas by-pass line connecting the reactive gas supply system to the vacuum evacuating system, the by-pass the reactive gas escape prevention valve is switched from the closed condition to an open condition, after a lapse of a specific delay time from the stopping of the supply of the source gas into the processing vessel ; and

the source gas escape prevention valve is switched from the closed condition to an open condition, after a lapse of a specific delay time from the stopping of the supply of the reactive gas into the processing vessel.

It is preferable that the source gas by-pass line is provided with a source gas buffer tank, while the reactive gas by-pass line is provided with a reactive gas buffer tank.

The reactive gas may be a reducing gas or an oxidation gas.

For example, the source gas is $WF_6$ gas, while the reducing gas is a silane-group gas or hydrogen gas.

It is preferable that the vacuum evacuating system is provided with a scrubber that eliminates an impurity gas in an evacuated gas. In this case, since a source gas and a reactive gas are not allowed to simultaneously flow into the vacuum evacuating system, a combustion decomposition efficiency of an impurity gas such as $SiH_4$ in a scrubber is improved, which increases detoxifying efficiency.

BRIEF DESCRIPTION OF THE DRAWINGS

Fig. 1 is a schematic view of a processing apparatus in a first embodiment according to the present invention;

Fig. 2 is a timing chart showing supply conditions of respective gases into a processing vessel of the apparatus shown in Fig. 1;

Fig. 3 is a table showing opening/closing conditions of the respective valves and flow conditions of the respective gases, in the apparatus show in Fig. 1;

Fig. 4 is a schematic view of an apparatus as a comparative example of the apparatus shown in Fig. 1;

Fig. 5 is a table showing opening/closing conditions of the respective valves and flow conditions of respective gases, in the apparatus shown in Fig. 4;

Fig. 6 is a schematic view of a processing apparatus in a second embodiment according to the present invention;

Fig. 7 is a table showing flow conditions of the respective gases in a film-deposition process performed by the apparatus shown in Fig. 6;

Fig. 8 is a schematic view showing a conventional single-wafer type processing apparatus;

Fig. 9 is a timing chart showing supply conditions of the respective gases in the apparatus shown in Fig. 8; and

Fig. 10 is a schematic view of another conventional processing apparatus.

DETAILED DESCRIPTION OF THE INVENTION

Embodiments of a processing apparatus according to the present invention are described hereinbelow with reference to the accompanying drawings.

First Embodiment

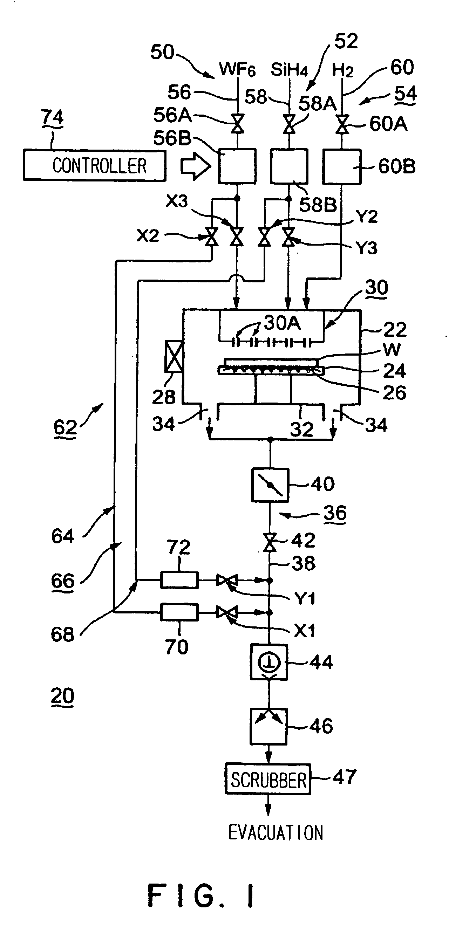

A first embodiment of the present invention shown in Figs. 1 to 3 are described at first. In the first embodiment, a process in which a tungsten film (seeding film) is formed by supplying alternately, intermittently $WF_6$ gas as a source gas and $SiH_4$ gas of a reducing gas as a reactive gas, is described as an example.

As shown in Fig. 1, a processing apparatus 20 includes a cylindrical processing vessel 22 an inside of which can be evacuated to form a vacuum. A table 24 is disposed in the processing vessel 22. An object to be processed, such as a semiconductor wafer W, can be supported on an upper surface of the table 24. A resistance heater 26 as heating means is buried in the table 24, so that the wafer W can be heated to a predetermined temperature and maintained thereat. In place of the resistance heater, a heating lamp may be used as the heating means.

A gate valve 28 is disposed on a sidewall of the processing vessel 22, which is opened and closed when the wafer W is loaded into the processing vessel 22 and unloaded therefrom. Gas-introducing means, such as a showerhead part 30, for introducing various gases required for a wafer processing to the processing vessel 22 is disposed on a top part of the processing vessel 22. Each of the gases can be jetted through a plurality of gas jetting holes 30A, so as to be introduced to the processing vessel 22. The plurality of gas jetting holes 30A are arranged in matrix. An inside of the showerhead part 30 may be constituted to form one diffusion chamber, or a plurality of separated diffusion chambers to prevent gases from mixing in the showerhead part 30. In the latter case, the gases are not mixed with each other until the gases are jetted from the gas jetting holes 30A. This gas supply condition is referred to as "post-mix". Although not shown, gases are supplied in the post-mix manner in this embodiment. The gas-introducing means is not limited to such a showerhead structure, and a gas can be supplied through a nozzle.

An exhaust port 34 is formed in a bottom part 32 of the processing vessel 22. A vacuum evacuating system 36 for exhausting an atmosphere in the processing vessel 22 to form therein a vacuum is connected to the exhaust port 34. To be specific, the vacuum evacuating system 36 is provided with an exhaust pipe 38 of relatively a larger diameter, which is connected to the exhaust port 34. The exhaust pipe 38 is provided with: a pressure control valve 40 formed of a butterfly valve whose valve opening can be adjusted to control a pressure in the processing vessel 22; a shut-off valve 42 for opening/closing the exhaust pipe 38 according to need; an upstream-side vacuum pump 44 formed of, e.g., a mechanical booster pump; and a downstream-side vacuum pump 46 formed of, e.g., a dry pump; which are disposed in this order from an upstream side to a downstream side of the exhaust pipe 38. The vacuum evacuating system 36 has a scrubber 47 at a downstream side of the downstream-side vacuum pump 46. The scrubber 47 burns to oxidize and decompose an impurity gas, such as $SiH_4$, contained in an evacuated gas so as to eliminate the same.

The showerhead part 30 is provided with: a source gas supply system 50 for selectively supplying a source gas into the processing vessel 22; and a reactive gas supply system 52 for selectively supplying a reactive gas into the processing vessel 22. In addition, the showerhead part 30 is provided with: a system for supplying another required gas, such as an $H_2$ gas supply system 54 for supplying $H_2$ gas; and an inert gas supply system such as an $N_2$ gas supply system (not shown) for supplying $N_2$ gas. A carrier gas is added to the source gas and the reactive gas, if necessary. In this embodiment, $WF_6$ gas is used as a source gas, while $SiH_4$ gas of a reducing gas is used as a reactive gas, so as to form a tungsten film by a thermal CVD method.

The source gas supply system 50 includes a source gas supply pipe 56 which is connected to the showerhead part 30. The source gas supply pipe 56 is provided with: a source gas valve 56A; a source gas flow rate controller 56 like a mass flow controller; and a first switching valve X3 for a source gas, which are disposed in this order from an upstream side to a downstream side of the source gas supply pipe 56.

The reactive gas supply system 52 includes a reactive gas supply pipe 58 which is connected to the showerhead part 30. The reactive gas supply pipe 58 is provided with: a reactive gas valve 58A; a reactive gas flow rate controller 58B like a mass flow controller; and a first switching valve Y3 for a reactive gas, which are disposed in this order from an upstream side to a downstream side of the reactive gas supply pipe 58.

The $H_2$ gas supply system 54 includes an $H_2$ gas supply pipe 60 which is connected to the showerhead part 30. The $H_2$ gas supply pipe 60 is provided with: an $H_2$ gas valve 60A; and an $H_2$ gas flow rate controller 60B like a mass flow controller; which are disposed in this order from an upstream side to a downstream side of the $H_2$ gas supply pipe 60.

A source gas by-pass line 62 bypassing the processing vessel 22 communicates the source gas supply system 50 to the vacuum evacuating system 36. A source gas is selectively caused to flow through the source gas by-pass line 62. Specifically, the source gas by-pass line 62 includes a source gas by-pass pipe 64 which is branched from the source gas supply pipe 56 at a position between the source gas flow rate controller 56B and the source gas first switching valve X3. A downstream end of the source gas by-pass pipe 64 is connected and communicated to the exhaust pipe 38 at a position between the shut-off valve 42 and the upstream-side vacuum pump 44. A second switching valve X2 for a source gas is disposed on an upstream side of the source gas by-pass pipe 64.

A reactive gas by-pass line 66 bypassing the processing vessel 22 communicates the reactive gas supply system 52 to the vacuum evacuating system 36. A reactive gas is selectively caused to flow through the reactive gas by-pass line 66. Specifically, the reactive gas by-pass line 66 includes a reactive gas by-pass pipe 68 which is branched from the reactive gas supply pipe 58 at a position between the reactive gas flow rate controller 58B and the reactive gas first switching valve Y3. A downstream end of the reactive gas by-pass pipe 68 is connected and communicated to the exhaust pipe 38 at a position between the shut-off valve 42 and the upstream-side vacuum pump 44. A second switching valve Y2 for a reactive gas is disposed on an upstream side of the reactive gas by-pass pipe 68. If necessary, the $H_2$ gas supply pipe 60 may have a by-pass pipe as described above.

A source gas escape prevention valve X1, which is a characteristic feature of the present invention, that prevents an escape of a source gas, is disposed on a most downstream side of the source gas by-pass pipe 64, i.e., just in front of a position where the source gas by-pass pipe 64 and the exhaust pipe 38 are converged. A source gas buffer tank 70 of a predetermined capacity to meet the need is disposed immediately upstream the source gas escape prevention valve X1. The source gas buffer tank 70 can temporarily stores therein a source gas. Thus, even when the source gas escape prevention valve X1 is closed, a source gas can be temporarily fed into the source gas by-pass pipe 64, that is, a pre-flow operation can be performed.

A reactive gas escape prevention valve Y1, which is a characteristic feature of the present invention, that prevents an escape of a reactive gas, is disposed on a most downstream side of the reactive gas by-pass pipe 68, i.e., just in front of a position where the reactive gas by-pass pipe 68 and the exhaust pipe 38 are converged. A reactive gas buffer tank 72 of a predetermined capacity to meet the need is disposed immediately upstream the reactive gas escape prevention valve Y1. The reactive gas buffer tank 72 can temporarily stores therein a reactive gas. Thus, even when the reactive gas escape prevention valve Y1 is closed, a reactive gas can be temporarily fed into the reactive gas by-pass pipe 68, that is, a pre-flow operation can be performed.

There is disposed a gas supply controller 74, which is formed of a microcomputer or the like, that controls the gas supply systems. To be specific, the gas supply controller 74 directly controls to open and/or close the source gas supply system 50 (including the source gas first switching valve X3), the source gas by-pass line 62 (including the source gas second switching valve X2), the reactive gas supply system 52 (including the reactive gas first switching valve Y3), the reactive gas by-pass line 66 (including the reactive gas second switching valve Y2), the source gas escape prevention valve X1, and the reactive gas escape prevention valve Y1.

A film-deposition method carried out by the processing apparatus as constituted above is described hereinbelow.

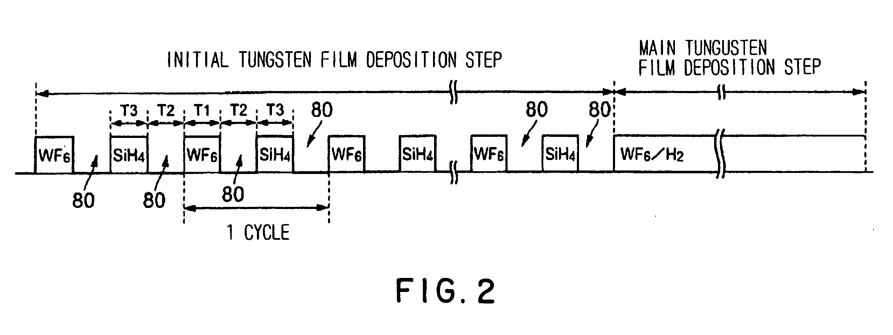

An example of a film-deposition method is described referring to Fig. 2, in which an initial tungsten film deposition step for depositing an initial tungsten film for seeding a film is performed at first, and thereafter a main tungsten film deposition step for depositing a main tungsten film is successively performed. In this example, a process pressure is set at about 1000 Pa, and a process temperature is set at about 410°C. However, the parameters are not limited to these values.

Fig. 2 is a timing chart showing supply conditions of the gases into the processing vessel 22. As shown in Fig. 2, in the initial tungsten film deposition step, $WF_6$ gas as a source gas and $SiH_4$ gas of a reducing gas as a reactive gas are alternately, intermittently supplied at different timings. In other words, a $WF_6$ gas supply step and an $SiH_4$ gas supply step are alternately performed, and a purge step 80 is carried out between the repeated supply steps. The purge step 80 is carried out by supplying $N_2$ gas and evacuating the remaining gas. A supply period T1 for $WF_6$ gas, a supply period T3 for $SiH_4$ gas, and a purge period T2 are respectively about 1.5 seconds for each time. For example, when $WF_6$ gas is once supplied into the processing vessel 22, molecules of the $WF_6$ gas adhere to a surface of the wafer to form about one layer. After the gas remaining in the processing vessel 22 is discharged, $SiH_4$ gas is once supplied thereinto. Then, the $SiH_4$ gas reacts with the $WF_6$ gas adhered to the wafer surface, so that a significantly thin tungsten film having a thickness corresponding to a single molecule or a plurality of molecules is formed. Such a tungsten film is repeatedly deposited. A thickness of a tungsten film formed in a single cycle consisting of one supply of $WF_6$ gas and one supply of $SiH_4$ gas, is about 10Å, although it depends on process conditions.

As described above, an initial tungsten film is formed by repeating the predetermined number of cycles, for example, 20 to 30 cycles. Subsequently, $WF_6$ gas and $H_2$ gas are simultaneously fed into the processing vessel 22, so that a main tungsten film is formed at a higher film-deposition rate.

In the initial tungsten film deposition step, in order to stabilize a flow rate of $WF_6$ gas or $SiH_4$ gas, a pre-flow operation is performed for a few seconds, e.g., about three seconds, before $WF_6$ gas or $SiH_4$ gas is actually supplied into the processing vessel 22 on the above-described cycle basis. As described above, the $WF_6$ gas and the $SiH_4$ gas used for the pre-flow operation do not pass through the processing vessel 22, but pass through the respective by-pass pipes 64 and 68 to be directly discharged to the vacuum evacuating system 36. At this time, in the present invention, an opening/closing operation of the respective valves is controlled so as not to allow the $WF_6$ gas and the $SiH_4$ gas to simultaneously flow into the vacuum evacuating system 36.

Concrete operations in the initial tungsten film deposition step are described. During this process, the vacuum pumps 44 and 46 of the vacuum evacuating system 36 are continuously driven. Naturally, the shut-off valve 42 of the exhaust pipe 38 is maintained to be opened. The source gas valve 56A of the source gas supply system 50 for $WF_6$ gas, and the reactive gas valve 58A of the reactive gas supply system 52 for $SiH_4$ gas are constantly opened.

In order to supply $WF_6$ gas into the processing vessel 22 under this state, the source gas first switching valve X3 disposed on the source gas supply pipe 56 is opened, while the source gas second switching valve X2 disposed on the source gas by-pass pipe 64 is closed. On the other hand, in order to supply or introduce $WF_6$ gas to the source gas by-pass pipe 64 in place of the processing vessel 22, the source gas first switching valve X3 is closed, while the source gas second switching valve X2 is opened.

It is important that, during the pre-flow operation, when $WF_6$ gas is introduced to the source gas by-pass pipe 64 with the source gas second switching valve X2 being opened, the source gas escape prevention valve X1 disposed downstream the source gas second switching valve X2 is maintained to be closed, so that the $WF_6$ gas is not allowed to escape to the vacuum evacuating system 36. The source gas buffer tank 70 of a predetermined capacity is disposed on the source gas by-pass pipe 64, in order to assure that, when the source gas escape prevention valve X1 is closed, the $WF_6$ gas can be introduced to the source gas by-pass pipe 64. In other words, although for a short period of time, the source gas buffer tank 70 makes it possible for the $WF_6$ gas to flow as a pre-flow through the source gas by-pass pipe 64, when the source gas escape prevention valve X1 is closed. This is true of a case where $SiH_4$ gas is supplied into the reactive gas by-pass pipe 68. That is, in order to supply $SiH_4$ gas into the processing vessel 22, the reactive gas first switching valve Y3 disposed on the reactive gas supply pipe 58 is opened, while the reactive gas second switching valve Y2 disposed on the reactive gas by-pass pipe 68 is closed. On the other hand, in order to supply or introduce $SiH_4$ gas to the reactive gas by-pass pipe 68 in place of the processing vessel 22, the reactive gas first switching valve Y3 is closed, while the reactive gas second switching valve Y2 is opened.

It is important that, during the pre-flow operation, when $SiH_4$ gas is introduced to the reactive gas by-pass pipe 68 with the reactive gas second switching valve Y2 being opened, the reactive gas escape prevention valve Y1 disposed downstream the reactive gas second switching valve Y2 is maintained to be closed, so that the $SiH_4$ gas is not allowed to escape to the vacuum evacuating system 36. The reactive gas buffer tank 72 of a predetermined capacity is disposed on the reactive gas by-pass pipe 68, in order to assure that, when the reactive gas escape prevention valve Y1 is closed, the $SiH_4$ gas can be introduced to the reactive gas by-pass pipe 68. In other words, although for a short period of time, the reactive gas buffer tank 72 makes it possible for the $SiH_4$ gas to flow as a pre-flow through the reactive gas by-pass pipe 68, when the reactive gas escape prevention valve Y1 is closed.

A timing for discharging the $WF_6$ gas stored in the buffer tank 70 to the vacuum evacuating system 36 by opening the gas escape prevention valve X1 may be an occasion when $WF_6$ gas is supplied into the processing vessel 22. Also, a timing for discharging the $SiH_4$ stored in the buffer tank 72 to the vacuum evacuating system 36 by opening the gas escape prevention valve Y1 may be an occasion when $SiH_4$ gas is supplied into the processing vessel 22.

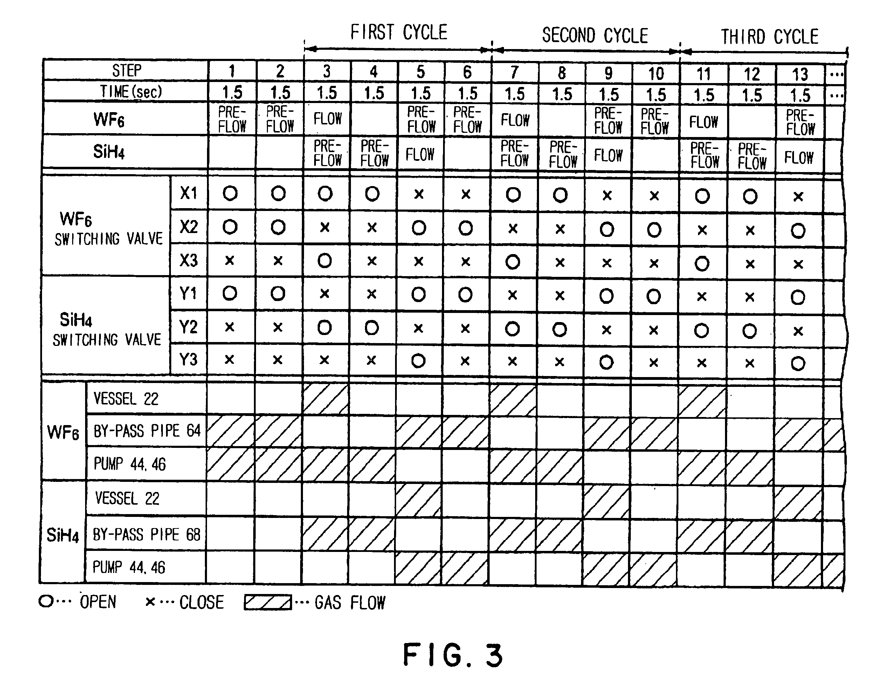

Opening/closing operations of the respective valves and flow conditions of the gases are described in detail below with reference to Fig. 3.

In Fig. 3, the term "pre-flow" means a condition in which a pre-flow operation is carried out, and the term "flow" means a condition in which a flow operation, i.e., a supply of gas into the processing vessel 22 is carried out. The pre-flow operation for each gas is carried out for three seconds. After that, the flow operation, in which each gas is fed into the processing vessel 22, is carried out for 1.5 seconds. The mark "○" indicates an open condition of each of the valves and the switching valves, and the mark "×" indicates a closed condition thereof.

Diagonal lines mean that a gas is actually fed into the processing vessel 22, the by-pass pipes 64 and 68, and the vacuum pumps 44 and 46. An absence of the diagonal lines means that a gas is not fed thereinto.

In the steps 1 and 2 as an initial stage, as to $WF_6$ gas, by opening the valves X1 and X2 and closing the valve X3, $WF_6$ gas is fed into the by-pass pipe 64 and the vacuum pumps 44 and 46 to carry out the pre-flow operation, so that a flow rate of the $WF_6$ gas is stabilized. At this time, as to $SiH_4$ gas, by closing the valves Y2 and Y3 and opening the valve Y1, the by-pass pipe 68 and the reactive gas buffer tank 72 are sufficiently evacuated to form therein a vacuum, so as to prepare the succeeding pre-flow operation.

In the step 3, as to $WF_6$ gas, the valve X2 is switched from the open condition to the closed condition, and the valve X3 is switched from the closed condition to the open condition, with the valve X1 being maintained to be opened. Thus, a flow of the $WF_6$ gas into the by-pass pipe 64 stops, that is, the pre-flow operation stops. In place thereof, $WF_6$ gas is fed into the processing vessel 22 to carry out the flow operation. The $WF_6$ gas continuously flows into the vacuum pumps 44 and 46. At this moment, since the valve X1 is in the open condition, the $WF_6$ gas fed into the by-pass pipe 64 and stored in the source gas buffer tank 70 in the preceding pre-flow operation is evacuated and discharged. Thus, a high vacuum is formed in the by-pass pipe 64 and the source gas buffer tank 70 to prepare the succeeding pre-flow operation.

Meanwhile, as to $SiH_4$ gas, the valve Y3 is maintained to be closed so as not to allow $SiH_4$ gas to flow into the processing vessel 22. By switching the valve Y2 from the closed condition to the open condition and by switching the valve Y1 from the open condition to the closed condition, $SiH_4$ gas is fed into the reactive gas by-pass pipe 68 and the reactive gas buffer tank 72, both forming a high vacuum, so that the pre-flow operation is carried out. At this time, as described above, since the valve Y1 is in the closed condition, the $SiH_4$ gas is not allowed to flow into the vacuum pumps 44 and 46. As a result, inner surfaces of the pumps 44 and 46 and the vacuum evacuating system 36 through which the $WF_6$ gas flows are prevented from deposition of a tungsten film.

In the step 4, as to $WF_6$ gas, the valve X3 is switched from the open condition to the closed condition, with maintaining the closed condition of the valve X2 and the open condition of the valve X1. Thus, a supply of $WF_6$ gas into the processing vessel 22 stops. At the same time, by supplying $N_2$ gas, not shown, into the processing vessel 22, the processing vessel 22 is evacuated to discharge the gas remaining therein. At this moment, the $WF_6$ gas remaining in the processing vessel 22 flows into the vacuum pumps 44 and 46, while the source gas by-pass pipe 64 and the source gas buffer tank 70 are continuously evacuated to form a high vacuum, so as to prepare the succeeding pre-flow operation.

Meanwhile, as to $SiH_4$ gas, the conditions in the step 3 are maintained as they are, to continue the pre-flow operation. That is, the step 4 corresponds to the purge step 80 shown in Fig. 2.

In the step 5, as to $WF_6$ gas, the valve X1 is switched from the open condition to the closed condition, and the valve X2 is switched from the closed condition to the open condition, with the valve X3 being maintained to be closed. Thus, $WF_6$ gas is fed into the source gas by-pass pipe 64 and the source gas buffer tank 70, both forming a high vacuum, so that the pre-flow operation is carried out. At this time, as described above, since the valve X1 is in the closed condition, the $WF_6$ gas is not allowed to flow into the vacuum pumps 44 and 46. As a result, the inner surfaces of the pumps 44 and 46 through which the $SiH_4$ gas flows are prevented from deposition of a tungsten film.

As to $SiH_4$ gas, the valves Y1 and Y3 are respectively switched from the closed condition to the open condition, while the valve Y2 is switched from the open condition to the closed condition. Thus, $SiH_4$ gas is fed into the processing vessel 22 so that the flow operation is carried out. At the same time, a supply of the $SiH_4$ gas into the reactive gas by-pass pipe 68 is stopped to complete the pre-flow operation. At this time, since the valve Y1 is in the open condition, the reactive gas by-pass pipe 68 and the reactive gas buffer tank 72 are evacuated to form a high vacuum, so as to prepare the succeeding pre-flow operation. In the step 5, the WF6 gas adhering to the surface of the wafer W in the step 3 and the $SiH_4$ gas supplied in the step 5 react with each other, so that a thin tungsten film is formed on the wafer surface.

In the step 6, as to $WF_6$ gas, the conditions of the respective valves X1, X2, and X3 are maintained as they are in the step 5, to continue the pre-flow operation.

Meanwhile, as to $SiH_4$ gas, the valve Y3 is switched from the open condition to the closed condition, with maintaining the open condition of the valve Y1 and the closed condition of the valve Y2. Thus, a supply of $SiH_4$ gas into the processing vessel 22 stops. At the same time, by supplying $N_2$ gas, not shown, into the processing vessel 22, the processing vessel 22 is evacuated to discharge the gas remaining therein. At this time, the $SiH_4$ gas remaining in the processing vessel 22 flows into the vacuum pumps 44 and 46, while the reactive gas by-pass pipe 68 and the reactive gas buffer tank 72 are evacuated to form a high vacuum, so as to prepare the succeeding pre-flow operation. That is, the step 6 corresponds to the purge step 80 in Fig. 2. The steps 3 to 6 constitute a single cycle, and the cycle is repeated for the required number of times, e.g., 20 to 30 times.

As described above, a film is deposited by supplying a source gas and a reactive gas (a reducing gas in this embodiment) intermittently, alternately supplied into the processing vessel 22 at different timings in a repeated manner. In the film-deposition process, when the pre-flow operation for each gas is repeatedly carried out immediately before each gas is supplied into the processing vessel 22, it is possible to prevent both of the gases from mixing to each other and simultaneously flowing into the vacuum evacuating system 36 having the vacuum pumps 44 and 46. Thus, it is possible to prevent formation and adhesion of a tungsten film in the vacuum pumps 44 and 46. As a result, the vacuum evacuating system 36 having the vacuum pumps 44 and 46 can be prevented from being damaged.

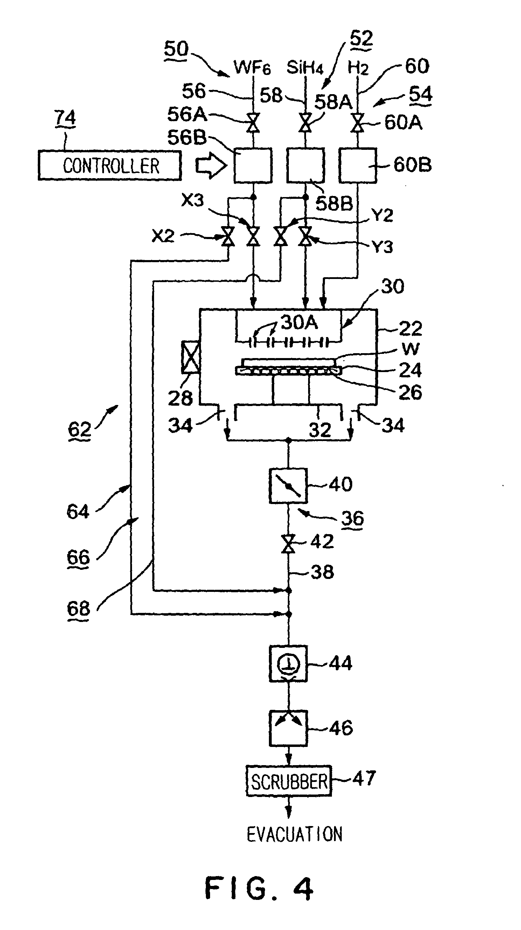

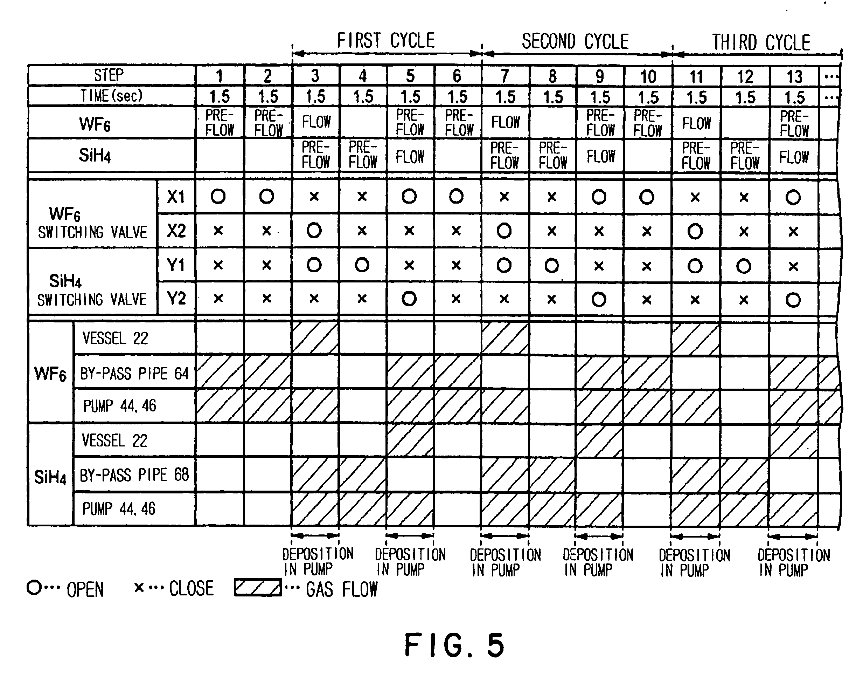

Figs. 4 shows a comparative example of the processing apparatus in the first embodiment of the present invention, and Fig. 5 shows opening/closing conditions of the valves and flow conditions of the gases, in the apparatus as a comparative example show in Fig. 4. Film-deposition processes were respectively carried out by the apparatus in the first embodiment and the apparatus as a comparative example, and the results were compared to each other. The evaluation results are described below.

The processing apparatus shown in Fig. 4 has the same structure as that of the processing apparatus shown in Fig. 1, except that the source gas escape prevention valve X1, the source gas buffer tank 70, the reactive gas escape prevention valve Y1, and the reactive gas buffer tank 72 are omitted. In Fig. 4, the same constituent parts are shown by the same reference numbers as in Fig. 1.

As shown in Fig. 5, in the processing apparatus shown in Fig. 4, when the pre-flow operation and the flow operation are simultaneously carried out in the steps 3, 5, 7, 9, 11, 13 ···, the mixed gases flow into the vacuum pumps 44 and 46. Thus, a tungsten film is deposited in the vacuum pumps 44 and 46, which gives damage thereto.

In each of the processing apparatuses, a heating-type trap was disposed in front of the upstream-side vacuum pump 44 of the vacuum evacuating system 36. A film-deposition process was carried out for six hours, while a tungsten film was trapped by the heating-type trap. In the processing apparatus as a comparative example, a trapped amount of the tungsten film was 6.7 g. On the other hand, in the processing apparatus according to the present invention, substantially no tungsten film was trapped. That is, an effectiveness of the processing apparatus according to the present invention could be confirmed.

In the first embodiment, the buffer tanks 70 and 72 are disposed on the by-pass pipes 64 and 68, respectively. However, the buffer tanks 70 and 72 may be omitted, when each of the by-pass pies 64 and 68 has a sufficiently large inner diameter and a sufficient pipe length, so that a pipe capacity corresponding to a capacity of each of the buffer tanks 70 and 72 can be assured.

An example of a design of each of the buffer tanks 70 and 72 is explained. In the flow rate controllers 56B and 58B each controls a gas flow rate like a mass flow controller, a ratio of a downstream pressure relative to an upstream pressure must be set at equal to or less than 0.5, such that a flow velocity reaching the sonic speed maintains an ultrasonic nozzle state.

Suppose that a maximum flow rate of the mass flow controller is 450 sccm, and a time period for the pre-flow operation is 3 seconds. When an upstream pressure of the mass flow controller is 70,000 Pa, a downstream pressure must be maintained at equal to or less than 35,000 Pa. A flow rate Q [Pa·m$^3$/sec] of the $WF_6$ gas used for the pre-flow operation is given by the following equation.

$$Q = 450 \times 10^{-6} \times 101325/60 = 0.76 \text{ Pa·m}^3/\text{sec}$$

Thus, a flow amount Pv [Pa·m$^3$] of the $WF_6$ gas used for the pre-flow operation is as follows.

$$Pv = 3 \times Q = 2.28 \ Pa \cdot m^3$$

Therefore, a minimum capacity V required by the buffer tank is given by the following equation according to the Boyle - Charles law.

$$V = Pv/\Delta P = 2.28/35000 = 6.5 \times 10^{-5} \ m^3$$

When the opening/closing operations of the respective valves are controlled by the gas supply controller 74 in this embodiment, the respective valves may be opened and/or closed by means of a delay timer. For example, the source gas escape prevention valve X1 is configured to interlock with the reactive gas first switching valve Y3, such that, for example, when the valve Y3 is switched to be opened, the valve X1 is switched to be closed, and that when the valve Y3 is switched from the open condition to the closed condition, the valve X1 is switched from the closed condition to the open condition, with a delay of 1.5 seconds.

Similarly, the reactive gas escape prevention valve Y 1 is configured to interlock with the source gas first switching valve X3, such that, for example, when the valve X3 is switched to be opened, the valve Y1 is switched to be closed, and that when the valve X3 is switched from the open condition to the closed condition, the valve Y1 is switched from the closed condition to the open condition, with a delay of 1.5 seconds.

In the first embodiment, the supply period of T1 for $WF_6$ gas, the supply period of T3 for $SiH_4$ gas, and the period T2 for the purge step (see, Fig. 2) are all set to be 1.5 seconds. However, this is only taken as an example, and the period is naturally not limited to the value. It is also needless to say that a time period for the pre-flow operation is not limited to 3 seconds.

Further, in the first embodiment, $WF_6$ gas is supplied as a source gas and $SiH_4$ gas of a reducing gas is supplied as a reactive gas. However, a reducing gas is not limited to $SiH_4$ gas, and may be $H_2$ gas, disilane, dichlorosilane, and so on. When another gas, such as $ZrCl_4$ is used as a source gas to deposit a film by oxidation, an oxidation gas such as $O_3$ gas may be used as a reactive gas.

Second Embodiment

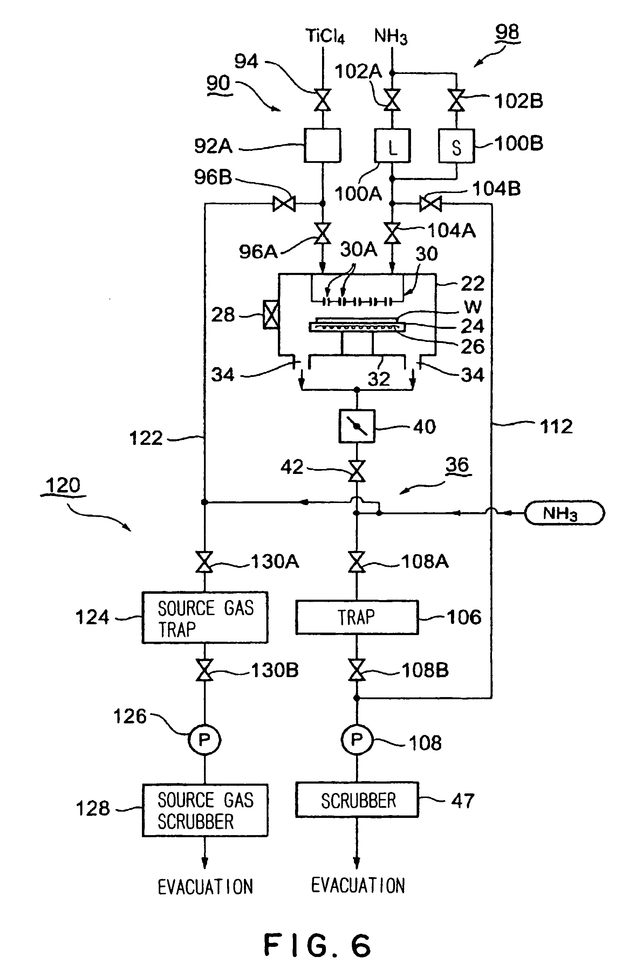

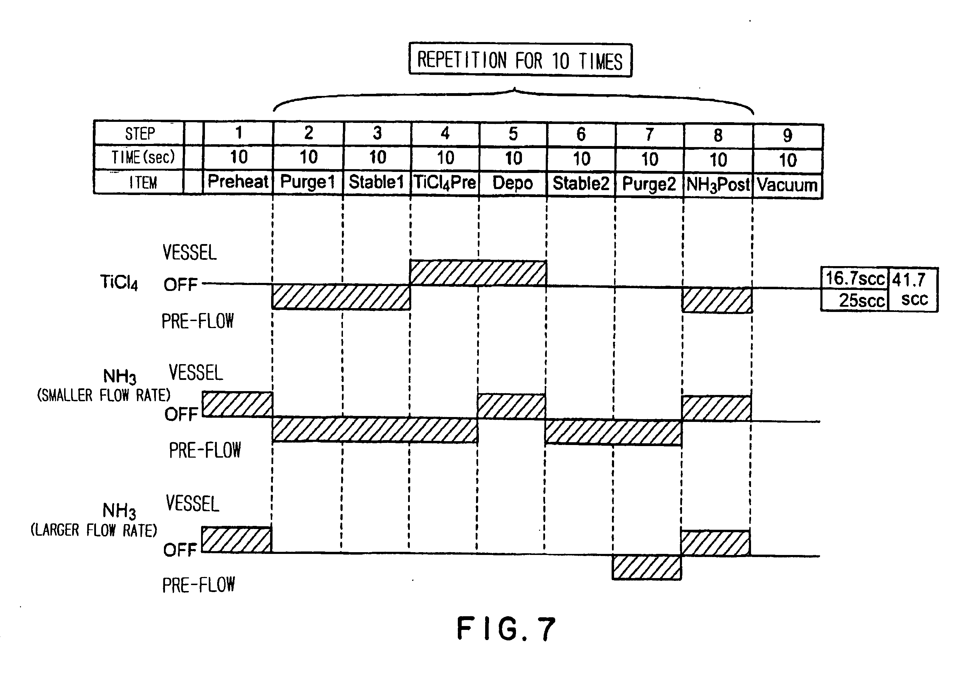

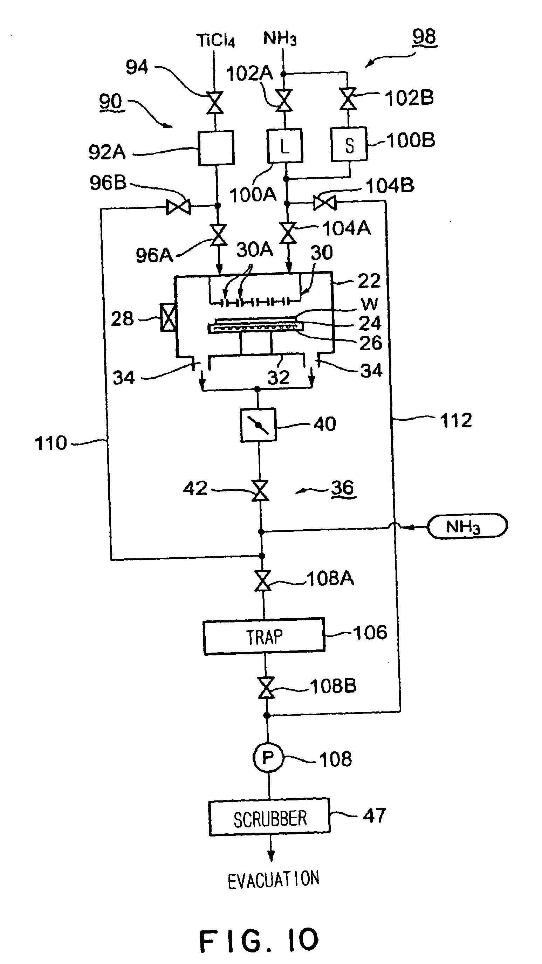

A second embodiment of the present invention shown in Figs. 6 and 7 is described, with also reference to a conventional example shown in Fig. 10. An object of the second embodiment is to restrain a maintenance frequency of a trap device disposed on a vacuum evacuating system. In the second embodiment, a TiN film is deposited by using $TiCl_4$ gas and $NH_3$ gas by a thermal CVD method.

A constitution of a processing vessel 22 of a conventional processing apparatus shown in Fig. 10 is the same as that of the processing vessel 22 shown in Fig. 1. Thus, the same parts are shown by the same reference numbers, and their description is omitted. A source gas supply system 90 for supplying, for example, $TiCl_4$ gas as a source gas is connected to a showerhead part 30 disposed in the processing vessel 22. A flow rate controller 92A for controlling a flow rate like a mass flow controller is disposed on the source gas supply system 90. A valve 94 is disposed upstream the flow rate controller 92A, and a first switching valve 96A is disposed downstream the flow rate controller 92A.

A reactive gas supply system 98 for supplying, for example, $NH_3$ gas as a reactive gas is connected to the showerhead part 30. There are a case in which $NH_3$ gas is used at a larger flow rate and a case in which $NH_3$ gas is used at a smaller flow rate. Two flow rate controllers 100A and 100B respectively corresponding to the flow rate ranges are disposed in parallel on the reactive gas supply system 98. Valves 102A and 102B are respectively disposed upstream the flow rate controllers 100A and 100B. By switching the valves 102A and 102B, a controlled flow rate range can be selected. For example, the flow rate controller 100A controls a larger flow rate range, while the flow rate controller 100B controls a smaller flow rate range. A first switching valve 104A is disposed on a most downstream side of the reactive gas supply system 98 but upstream the showerhead part 30.

A vacuum evacuating system 36 connected to an exhaust port 34 formed in the processing vessel 22 is provided with: a pressure control valve 40; a shut-off valve 42; a trap device 106;, a vacuum pump 108 like a dry pump; and a scrubber 47; which are disposed in this order from an upstream side of the vacuum evacuating system 36. The trap device 106 eliminates, from an evacuated gas, an impurity gas such as a remaining source gas and its reactive by-product gas. The scrubber 47 eliminates an impurity gas remaining in an evacuated gas by burning the impurity gas, for example. In order to facilitate trapping of $TiCl_4$ gas, $NH_3$ gas which will react with $TiCl_4$ gas can be introduced to an upstream side of the trap device 106, when it is required. A valve 108A is disposed immediately upstream the trap device 106; and a valve 108B is disposed immediately downstream the trap device 106. The valves 108A and 108B shut off the gas flow channels, during a maintenance operation of the trap device 106.

A source gas by-pass pipe 110 extends between a position downstream the flow rate controller 92A of the source gas supply system 90 and a position immediately upstream the trap device 106 of the vacuum evacuating system 36. A second switching valve 96B is disposed on a most upstream side of the source gas by-pass pipe 110. By switching the first and the second switching valves 96A and 96B, a source gas is caused to flow into the processing vessel 22, or bypass the same by passing through the source gas by-pass pipe 110. The source gas by-pass pipe 110 is mainly used to stabilize a source gas flow, by allowing a source gas to flow therethrough in place of the processing vessel 22.

A reactive gas by-pass pipe 112 as a reactive gas by-pass line extends between a position downstream the flow rate controllers 100A and 100B of the reactive gas supply system 98 and a position immediately downstream the trap device 106 of the vacuum evacuating system 36. A second switching valve 104B is disposed on a most upstream side of the reactive gas by-pass pipe 112. By switching the first and the second switching valves 104A and 104B, a reactive gas is caused to flow into the processing vessel 22, or bypass the same by passing through reactive gas by-pass pipe 112. The reactive gas by-pass pipe 112 is mainly used to stabilize a reactive gas flow, by allowing a reactive gas to flow therethrough in place of the processing vessel 22.

A downstream end of the reactive by-pass pipe 112 is connected to a position downstream the trap device 106. This is because, since $NH_3$ gas flowing through the reactive by-pass pipe 112 generates no reactive by-product, the $NH_3$ gas can be discharged without passing through the trap device 106. The trap device 106 removes $TiCl_4$ gas and a reactive by-product thereof such as $NH_4Cl$, TiClx (titanium chloride), and $TiO_2$ (titanium oxide).

When a TiN film is deposited by means of the processing apparatus by a thermal CVD method, the $TiCl_4$ gas which has been supplied into the processing vessel 22 for an actual film deposition and remains therein to be discharged, a reactive by-product gas of the $TiCl_4$ gas, and the $TiCl_4$ gas which has been fed into the source gas by-pass pipe 110 to stabilize a flow rate of the gas, are all caused to flow through the trap device 106 for elimination as described above.

Thus, the trap device 106 traps a large amount of substances for a short period, which increases a frequency of the maintenance operation of the trap device 106. Therefore, an operation rate of the processing apparatus is undesirably lowered. In addition, a large amount of a reactive by-product flowing through the pipes may block the same.

In order to solve these problems, the processing apparatus in the second embodiment is constituted as shown in Fig. 6. In Fig. 6, the same parts as those in Fig. 10 are shown by the same reference numbers, and their description is omitted.

In place of the source gas by-pass pipe 110 shown in Fig. 10, the processing apparatus shown in Fig. 6 includes an unnecessary source gas evacuating system 120. To be specific, similar to the source gas by-pass pipe 110 shown in Fig. 10, the unnecessary source gas evacuating system 120 has a gas pipe 122 which is branched from the source gas supply system 90. The gas pipe 122 is provided with: a second trap device 124 for a source gas; a second vacuum pump 126 for a source gas; and a scrubber 128 for a source gas; which are disposed in this order from an upstream side of the gas pipe 122. The second trap device 124 for a source gas has the same constitution as that of a first trap device 106 of the vacuum evacuating system 36. Similar to a first vacuum pump 108, the second vacuum pump 126 for a source gas is a vacuum pump like a dry pump. The scrubber 128 for a source gas removes an impurity gas ($TiCl_4$) in an evacuated gas, by burning the same, for example. A valve 130A is disposed immediately upstream the second trap device 124, and a valve 130B is disposed immediately downstream the second trap device 124. The valves 130A and 130B are closed during a maintenance operation of the trap device 124.

A downstream end of the unnecessary source gas evacuating system 120 is opened to an atmospheric air through the scrubber 128. During the pre-flow operation for stabilizing a flow rate of $TiCl_4$ gas, the $TiCl_4$ gas is discharged to an atmospheric air, i.e., outside the system, through the unnecessary source gas evacuating system 120. In order to facilitate trapping of $TiCl_4$ gas, $NH_3$ gas which will react with the $TiCl_4$ gas can be respectively introduced to an upstream side of the trap device 106 and an upstream side of the trap device 124 for a source gas, when it is required. Although not shown, a supply system for supplying an inert gas such as $N_2$ gas into the processing vessel 22 is actually disposed on the processing apparatus.

An example of a film-deposition process carried out by the processing apparatus is described below, with reference to Fig. 7. For example, $TiCl_4$ gas as a source gas and $NH_3$ gas as a reactive gas are alternately supplied into the processing vessel 22, so as to deposit thin TiN films one by one.

At "Preheat" in the step 1, a resistance heater 26 is turned on, so that a table 24 and a wafer W supported thereon are heated to a predetermined temperature and maintained thereat. The time required for the step is about 10 sec. At this time, $NH_3$ gas is supplied into the processing vessel 22 through the flow rate controller 100A for a larger flow rate and the flow rate controller 100B for a smaller flow rate, each controller controlling a flow rate of the $NH_3$ gas. It goes without saying that the vacuum evacuating system 36 is driven and evacuated to form a vacuum. Thereafter, the $NH_3$ gas at a smaller flow rate is continuously caused to flow by the flow rate controller 100B so as to stabilize a flow rate of the $NH_3$ gas. When $NH_3$ gas is not required for a film-deposition process, the $NH_3$ gas is not allow to flow through the processing vessel 22, but is discharged through the reactive gas by-pass pipe 112, which is described above.

Next, at "Purge 1" in the step 2, $TiCl_4$ gas is started to be fed into the gas pipe 122 of the unnecessary gas evacuating system 120, without allowing the $TiCl_4$ gas to enter the processing vessel 22, so that the pre-flow operation is carried out. As to $NH_3$ gas, the first and the second switching valves 104A and 104B are switched such that the $NH_3$ gas, which has been fed into the processing vessel 22, is now fed into the reactive gas by-pass pipe 112, so as to carry out the pre-flow operation. A supply of the $NH_3$ gas of a larger flow rate is now stopped. At this time, a flow rate of the $TiCl_4$ gas is in a range of from 5 sccm to 100 sccm, e.g., 50 sccm. A process period is in a range of from 0.1 sec to 15 sec, e.g., 10 sec.

Next, at "Stable 1" in the step 3, the conditions in the step 2 are kept continued in a range of from 0.1 sec to 15 sec, e.g., 10 sec, so as to stabilize a gas flow rate. A total flow rate of the $TiCl_4$ gas used for the pre-flow operation in the steps 2 and 3 is 16.7 scc.

Next, at "$TiCl_4$ Pre" in the step 4, the first and the second switching valves 96A and 96B for $TiCl_4$ gas are switched such that the $TiCl_4$ gas, which has been discharged through the gas pipe 122, is now supplied into the processing vessel 22. At this time, a flow rate of the $TiCl_4$ gas is in a range of from 5 sccm to 100 sccm, e.g., 50 sccm. A process period is in a range of from 0.1 sec to 15 sec, e.g., 10sec. In the step 4, the $TiCl_4$ gas is absorbed on a surface of the wafer W in the processing vessel 22 at a thickness of about a single layer or a plurality of layers in an atomic level or a molecular level.

Next, at "Depo" in the step 5, the first and the second switching valves 104A and 104B for $NH_3$ gas are switched such that the $NH_3$ gas at a smaller flow rate, which has been discharged, is now fed into the processing vessel 22, so that a film-deposition process is carried out. By allowing the $NH_3$ gas to flow through the processing vessel 22, the $NH_3$ gas reacts with the $TiCl_4$ gas attached on the surface of the wafer W to be thermally decomposed to deposit a thin TiN film (titanium nitride film) by a thermal CVD method. The $TiCl_4$ gas absorbed on the wafer surface functions as a nucleus for forming a TiN film, which results in a reduction in an incubation time. At this time, a process period is in a range of from 0.1 sec to 15 sec, e.g., 10 sec. A total flow rate of the $TiCl_4$ gas fed into the processing vessel 22 in the steps 4 and 5 is 16.7 scc.

Next, at "Stable 2" in the step 6, a flow of the $TiCl_4$ gas is stopped. The first and the second switching valves 104A and 104B for $NH_3$ gas are switched such that the $NH_3$ gas at a smaller flow rate, which has been fed into the processing vessel 22, is now fed into the reactive gas by-pass pipe 112. The process period is in a range of from 0.1 sec to 15 sec, e.g., 10 sec.

Next, at "Purge 2" in the step 7, the $NH_3$ gas at a larger flow rate is started to flow so as to stabilize a flow rate of the $NH_3$ gas. At this moment, the processing vessel 22 is evacuated, and a not shown inert gas such as $N_2$ gas is fed thereinto to discharge the remaining gas. This process period is in a range of from 0.1 sec to 15 sec, e.g., 10 sec.

Next at "$NH_3$ Post" in the step 8, the first and the second switching valves 104A and 104B are switched such that both the $NH_3$ gas at a larger flow rate and the $NH_3$ gas at a smaller flow rate are fed into the processing vessel 22. Therefore, a surface of the TiN film deposited on the wafer surface is modified or completely nitrided by the $NH_3$ gas. At the same time, $TiCl_4$ gas is started to be fed into the gas pipe 122 for stabilizing a flow rate of the gas, and the $TiCl_4$ gas is discharged through the gas pipe 122, without passing through the processing vessel 22. A flow rate of the $TiCl_4$ gas is in a range of from 5 sccm to 100 sccm, e.g., 50 sccm. A process period is in a range of from 0.1 sec to 15 sec, e.g., 10 sec. A total flow rate of the $TiCl_4$ gas used for the pre-flow operation in the step 8 is 8.3 scc.

Subsequently, a plurality of TiN films are deposited by repeating a cycle comprising the steps 2 to 8, about 5 to 50 times, e.g., 10 times.

Next, at "Vacuum" in the step 9, a supply of the gases is stopped, so that a film-deposition process is completed.

As described above, a total flow rate of the $TiCl_4$ gas at a single cycle is 41.7 scc as a whole. Out of the 41.7 scc $TiCl_4$ gas, 16.7 scc thereof is caused to flow through the first trap device 106 through the processing vessel 22, and the rest of 25 scc of the $TiCl_4$ gas is caused to flow through the second trap device 124 for a source gas. That is, since only about 40% (=16.7/41.7) of the total amount of the used $TiCl_4$ gas is caused to flow through the first trap device 106, a life duration of the first trap device 106 can be elongated about 2.5 times. Due to the elongated life duration, it is possible to restrain a maintenance frequency of the first trap device 106.

Since the amount of the $TiCl_4$ gas flowing through the vacuum evacuating system 36 is reduced, generation of a reactive by-product thereof can be restrained. Therefore, blockings of the pipes of the vacuum evacuating system 36 can be avoided.

In the second embodiment, although the second trap device 124 for a source gas is disposed on the unnecessary source gas evacuating system 120, the second trap device 124 may be omitted, and the $TiCl_4$ gas flowing through the gas pipe 122 may be eliminated by the scrubber 128 for a source gas. Alternatively, a plurality of, e.g., two second trap devices 124 may be disposed in parallel, and selectively used. In this case, it is not necessary to stop an operation of the processing apparatus during a maintenance operation of the trap device for a source gas, and hence an operating rate of the processing apparatus can be enhanced.

By omitting the scrubber 128 for a source gas of the unnecessary source gas evacuating system 120, a downstream end of the unnecessary source gas evacuating system 120 may be connected to a position between the scrubber 47 and the first trap device 106 of the vacuum evacuating system 36, so that the $TiCl_4$ gas flowing through the unnecessary source gas evacuating system 120 can be decomposed and eliminated by the scrubber 47.

In the second embodiment, the first and the second switching valves 96A and 96B which are separated from each other, and the first and the second switching valves 104A and 104B which are separated from each other, are used. However, in place thereof, a three-way valve having the same function may be used. In the embodiment, the explanation is made about one processing apparatus. However, when there are a plurality of processing apparatuses of the same structure, the second trap device 124, the second vacuum pump 126, and the scrubber 128 for a source gas can be commonly used, by means of the gas pipes 122 of the processing apparatuses.

In the embodiment, a film-deposition process for forming a TiN film by using $TiCl_4$ gas and $NH_3$ gas is described by way of an example. However, not limited thereto, the present invention can be applied in cases where a Ti film is formed; a W film or a WN film is formed by using $WF_6$ as a source gas; and a $Ta_2O_5$ film is formed by using PET (pentoethoxy tantalum). In addition, the present invention can be applied to a process in which a reactive by-product of other than a gas state, e.g., soild or liquid state, is generated in a reaction step of an $HfO_2$ film, $RuO_2$ film, and an $Al_2O_3$ film.

In the embodiment, a semiconductor wafer is taken as an example of an object to be processed. However, not limited thereto, the present invention can be naturally applied to an LCD substrate, a glass substrate, and so on.

## Claims

1.  A processing apparatus comprising:

    a processing vessel that contains therein an object to be processed;
    a source gas supply system that selectively supplies a source gas into the processing vessel;
    a reactive gas supply system that selectively supplies a reactive gas into the processing vessel;
    a vacuum evacuating system having a vacuum pump, that evacuates an atmosphere in the processing vessel to form therein a vacuum;
    a gas by-pass line connecting either one of the source gas supply system and the reactive gas supply system to the vacuum evacuating system, the gas by-pass line bypassing the processing vessel;
    a gas buffer tank provided in the gas by-pass line, that temporarily stores therein a gas; and
    an on-off valve disposed in the gas by-pass line between the gas buffer tank and the vacuum evacuating system.

2.  The processing apparatus according to claim 1, wherein
    the processing apparatus further comprises a gas supply controller that controls the source gas supply system, the reactive gas supply system and the on-off valve, such that the source gas and the reactive gas are not allowed to simultaneously flow into the vacuum evacuating system.

3.  The processing apparatus according to claim 1, wherein the reactive gas is a reducing gas.

4.  The processing apparatus according to claim 1, wherein the reactive gas is an oxidation gas.

5.  The processing apparatus according to claim 1, wherein
    the source gas is $WF_6$ gas, while the reactive gas is $SiH_4$ gas.

6.  The processing apparatus of claim 1, comprising:

    a source gas by-pass line connecting the source gas supply system to the vacuum evacuating system, the by-pass line bypassing the processing vessel;
    a source gas buffer tank provided in the source gas by-pass line, that temporarily stores therein the source gas;
    a first on-off valve disposed in the source gas by-pass line between the source gas buffer tank and the vacuum evacuating system;
    a reactive gas by-pass line connecting the reactive gas supply system to the vacuum evacuating system, the by-pass line bypassing the processing vessel;
    a reactive gas buffer tank provided in the reactive gas by-pass line, that temporarily stores therein the reactive gas; and
    a second on-off valve disposed in the reactive gas by-pass line between the reactive gas buffer tank and the vacuum evacuating system.

7.  The processing apparatus according to claim 6, wherein
    the processing apparatus further comprises a gas supply controller that controls the source gas supply system, the reactive gas supply system, the first on-off valve and the second on-off valve, such that the source gas and the reactive gas are not allowed to simultaneously flow into the vacuum evacuating system.

8. The processing apparatus according to claim 7, wherein
   the gas supply controller is configured to carry out procedures in which:

   the source gas and the reactive gas are alternately, intermittently fed into the processing vessel;
   while the source gas is fed into the processing vessel, the second on-off valve is closed; and
   while the reactive gas is fed into the processing vessel, the first on-off valve is closed.

9. The processing apparatus according to claim 8, wherein
   the gas supply controller in configured to carry out procedures in which:

   the second on-off valve is switched from a closed condition to an open condition when a supply of the source gas is stopped; and
   the first on-off valve is switched from a closed condition to an open condition when a supply of the reactive gas is stopped.

10. The processing apparatus according to claim 9, wherein
    the gas supply controller is configured to carry out procedures in which:

    the second on-off valve is switched from a closed condition to an open condition after a lapse of a specific delay time from the stopping of the supply of the source gas into the processing vessel; and
    the first on-off valve is switched from a closed condition to an open condition after a lapse of a specific delay time from the stopping of the supply of the reactive gas into the processing vessel.

11. The processing apparatus according to claims 6, wherein
    the reactive gas is a reducing gas.

12. The processing apparatus according to claim 6, wherein
    the reactive gas is an oxidation gas.

13. The processing apparatus according to claim 6, wherein
    the source gas is $WF_6$ gas, while the reactive gas is $SiH_4$ gas.


**Patentansprüche**

1. Bearbeitungsvorrichtung mit folgenden Merkmalen:

   ein Bearbeitungsgefäß, welches ein zu bearbeitendes Objekt enthält;
   ein Quellengas-Versorgungssystem, welches dem Bearbeitungsgefäß ein Quellengas selektiv zuführt;
   ein Reaktivgas-Versorgungssystem, welches dem Bearbeitungsgefäß ein reaktives Gas selektiv zuführt;
   ein Vakuum-Evakuierungssystem mit einer Vakuumpumpe, das eine Atmosphäre in dem Bearbeitungsgefäß evakuiert, um ein Vakuum darin auszubilden;
   eine Gas-Umgehungsleitung, die entweder das Quellengas-Versorgungssystem oder das Reaktivgas-Versorgungssystem mit dem Vakuum-Evakuierungssystem verbindet, wobei die Gas-Umgehungsleitung das Bearbeitungsgefäß umgeht;
   ein Gas-Puffer-Tank, der in der Gas-Umgehungsleitung vorgesehen ist und ein Gas vorübergehend speichert; und
   ein Ein-Aus-Ventil, das in der Gas-Umgehungsleitung zwischen dem Gas-Puffertank und dem Vakuum-Evakuierungssystem angeordnet ist.

2. Bearbeitungsvorrichtung nach Anspruch 1, wobei
   die Bearbeitungsvorrichtung ferner eine Gasversorgungs-Steuereinrichtung umfasst, welche das Quellengas-Versorgungssystem, das Reaktivgas-Versorgungssystem und das Ein-Aus-Ventil steuert, so dass das Quellengas und das reaktive Gas nicht gleichzeitig in das Vakuum-Evakuierungssystem strömen können.

3.  Bearbeitungsvorrichtung nach Anspruch 1, wobei das reaktive Gas ein Reduktionsgas ist.

4.  Bearbeitungsvorrichtung nach Anspruch 1, wobei das reaktive Gas ein Oxidationsgas ist.

5.  Bearbeitungsvorrichtung nach Anspruch 1, wobei das Quellengas $WF_6$-Gas ist, während das reaktive Gas $SiH_4$-Gas ist.

6.  Bearbeitungsvorrichtung nach Anspruch 1 mit folgenden Merkmalen:

    eine Quellengas-Umgehungsleitung, welche das Quellengas-Versorgungssystem mit dem Vakuum-Evakuierungssystem verbindet, wobei die Umgehungsleitung das Bearbeitungsgefäß umgeht;
    ein Quellengas-Puffertank, der in der Quellengas-Umgehungsleitung vorgesehen ist und das Quellengas vorübergehend speichert;
    ein erstes Ein-Aus-Ventil, das in der Quellengas-Umgehungsleitung zwischen dem Quellengas-Puffertank und dem Vakuum-Evakuierungssystem angeordnet ist;
    eine Reaktivgas-Umgehungsleitung, welche das Reaktivgas-Versorgungssystem mit dem Vakuum-Evakuierungssystem verbindet, wobei die Umgehungsleitung das Bearbeitungsgefäß umgeht;
    ein Reaktivgas-Puffertank, der in der Reaktivgas-Umgehungsleitung angeordnet ist und das reaktive Gas vorübergehend speichert; und
    ein zweites Ein-Aus-Ventil, das in der Reaktivgas-Umgehungsleitung zwischen dem Reaktivgas-Puffertank und dem Vakuum-Evakuierungssystem angeordnet ist.

7.  Bearbeitungsvorrichtung nach Anspruch 6, wobei
    die Bearbeitungsvorrichtung ferner eine Gasversorgungs-Steuereinrichtung umfasst, welche das Quellengas-Versorgungssystem, das Reaktivgas-Versorgungssystem, das erste Ein-Aus-Ventil und das zweite Ein-Aus-Ventil steuert, so dass das Quellengas und das Reaktivgas nicht gleichzeitig in das Vakuum-Evakuierungssystem strömen können.

8.  Bearbeitungsvorrichtung nach Anspruch 7, wobei
    die Gasversorgungs-Steuereinrichtung dazu konfiguriert ist, Prozeduren auszuführen, bei denen:

    das Quellengas und das reaktive Gas abwechselnd intermettierend in das Bearbeitungsgefäß gespeist werden;
    wobei das zweite Ein-Aus-Ventil geschlossen ist, wenn das Quellengas in das Bearbeitungsgefäß gespeist wird; und
    das erste Ein-Aus-Ventil geschlossen ist, wenn das reaktive Gas in das Bearbeitungsgefäß gespeist wird.

9.  Bearbeitungsvorrichtung nach Anspruch 8, wobei
    die Gasversorgungs-Steuereinrichtung dazu konfiguriert ist, Prozeduren auszuführen, bei denen:

    das zweite Ein-Aus-Ventil von einem geschlossenen Zustand in einem geöffneten Zustand umgeschaltet wird, wenn eine Zufuhr des Quellengases gestoppt wird; und
    das erste Ein-Aus-Ventil von einem geschlossenen Zustand in einem offenen Zustand umgeschaltet wird, wenn eine Zufuhr des reaktiven Gases gestoppt wird.

10. Bearbeitungsvorrichtung nach Anspruch 9, wobei
    die Gasversorgungs-Steuereinhchtung dazu konfiguriert ist, Prozeduren auszuführen, bei denen:

    das zweite Ein-Aus-Ventil von einem geschlossenen Zustand in einem geöffneten Zustand umgeschaltet wird, nachdem eine vorgegebene Verzögerungszeit nach der Unterbrechung der Zufuhr des Quellengases in das Bearbeitungsgefäß verstrichen ist; und
    das erste Ein-Aus-Ventil von einem geschlossenen Zustand in einem geöffneten Zustand umgeschaltet wird, nachdem eine vorgegebene Verzögerungszeit nach der Unterbrechung der Zufuhr des reaktiven Gases in das Bearbeitungsgefäß verstrichen ist.

11. Bearbeitungsvorrichtung nach Anspruch 6, wobei
    das reaktive Gas ein Reduktionsgas ist.

12. Bearbeitungsvorrichtung nach Anspruch 6, wobei

das reaktive Gas ein Oxidationsgas ist.

**13.** Bearbeitungsvorrichtung nach Anspruch 6, wobei
das Quellengas $WF_6$-Gas ist, während das reaktive Gas $SiH_4$-Gas ist.

**Revendications**

**1.** Appareil de traitement comprenant :

► un récipient de traitement qui contient à l'intérieur de celui-ci un objet à traiter ;
► un système d'alimentation de gaz brut qui fournit sélectivement un gaz brut dans le récipient de traitement ;
► un système d'alimentation de gaz réactif qui fournit sélectivement un gaz réactif dans le récipient de traitement ;
► un système d'évacuation de dépression ayant une pompe de dépression, qui évacue une atmosphère dans le récipient de traitement pour former une dépression à l'intérieur de celui-ci ;
► une conduite de dérivation de gaz reliant le système d'alimentation de gaz brut ou le système d'alimentation de gaz réactif au système d'évacuation de dépression, la conduite de dérivation de gaz contournant le récipient de traitement ;
► un réservoir tampon de gaz disposé dans la conduite de dérivation de gaz, qui stocke provisoirement un gaz à l'intérieur de celui-ci ; et
► une vanne à ouverture-fermeture disposée dans la conduite de dérivation de gaz entre le réservoir tampon de gaz et le système d'évacuation de dépression.

**2.** Appareil de traitement selon la revendication 1, dans lequel l'appareil de traitement comprend en outre un contrôleur d'alimentation de gaz qui contrôle le système d'alimentation de gaz brut, le système d'alimentation de gaz réactif et la vanne à ouverture-fermeture, de sorte que le gaz brut et le gaz réactif ne soient pas autorisés à s'écouler simultanément dans le système d'évacuation de dépression.

**3.** Appareil de traitement selon la revendication 1, dans lequel le gaz réactif est un gaz réducteur.

**4.** Appareil de traitement selon la revendication 1, dans lequel le gaz réactif est un gaz oxydant.

**5.** Appareil de traitement selon la revendication 1, dans lequel le gaz brut est un gaz $WF_6$, alors que le gaz réactif est un gaz $SiH_4$.

**6.** Appareil de traitement selon la revendication 1, comprenant :

► une conduite de dérivation de gaz brut reliant le système d'alimentation de gaz brut au système d'évacuation de dépression, la conduite de dérivation contournant le récipient de traitement ;
► un réservoir tampon de gaz brut disposé dans la conduite de dérivation de gaz brut qui stocke provisoirement le gaz brut à l'intérieur de celui-ci ;
► une première vanne à ouverture-fermeture disposée dans la conduite de dérivation de gaz brut entre le réservoir tampon de gaz brut et le système d'évacuation de dépression ;
► une conduite de dérivation de gaz réactif reliant le système d'alimentation de gaz réactif au système d'évacuation de dépression, la conduite de dérivation contournant le récipient de traitement ;
► un réservoir tampon de gaz réactif disposé dans la conduite de dérivation de gaz réactif, qui stocke provisoirement le gaz réactif à l'intérieur de celui-ci ; et
► une seconde vanne à ouverture fermeture disposée dans la conduite de dérivation de gaz réactif entre le réservoir tampon de gaz réactif et le système d'évacuation de dépression.

**7.** Appareil de traitement selon la revendication 6, dans lequel l'appareil de traitement comprend en outre un contrôleur d'alimentation de gaz qui contrôle le système d'alimentation de gaz brut, le système d'alimentation de gaz réactif, la première vanne à ouverture-fermeture et la seconde vanne à ouverture-fermeture, de sorte que le gaz brut et le gaz réactif ne soient pas autorisés à s'écouler simultanément dans le système d'évacuation de dépression.

**8.** Appareil de traitement selon la revendication 7, dans lequel le contrôleur d'alimentation de gaz est configuré pour effectuer des procédures dans lesquelles :

► le gaz brut et le gaz réactif sont alimentés en alternance et par intermittence dans le récipient de traitement ;

► pendant que le gaz brut est alimenté dans le récipient de traitement, la seconde vanne à ouverture-fermeture est fermée ; et

► pendant que le gaz réactif est alimenté dans le récipient de traitement, la première vanne à ouverture-fermeture est fermée.

9. Appareil de traitement selon la revendication 8, dans lequel le contrôleur d'alimentation de gaz est configuré pour effectuer des procédures dans lesquelles :

► la seconde vanne à ouverture-fermeture est commutée d'un état fermé à un état ouvert lorsqu'une alimentation de gaz brut est arrêtée ; et

► la première vanne à ouverture-fermeture est commutée d'un état fermé à un état ouvert lorsqu'une alimentation de gaz réactif est arrêtée.

10. Appareil de traitement selon la revendication 9, dans lequel le contrôleur d'alimentation de gaz est configuré pour effectuer des procédures dans lesquelles :

► la seconde vanne à ouverture-fermeture est commutée d'un état fermé à un état ouvert après l'écoulement d'une temporisation spécifique à partir de l'arrêt de l'alimentation du gaz brut dans le récipient de traitement ; et

► la première vanne à ouverture-fermeture est commutée d'un état fermé à un état ouvert après l'écoulement d'une temporisation spécifique à partir de l'arrêt de l'alimentation du gaz réactif dans le récipient de traitement.

11. Appareil de traitement selon la revendication 6, dans lequel le gaz réactif est un gaz réducteur.

12. Appareil de traitement selon la revendication 6, dans lequel le gaz réactif est un gaz oxydant.

13. Appareil de traitement selon la revendication 6, dans lequel le gaz brut est un gaz $WF_6$, alors que le gaz réactif est un gaz $SiH_4$.

FIG. 1

FIG. 2

| | | FIRST CYCLE | | | | | | SECOND CYCLE | | | | THIRD CYCLE | | | |
|---|---|---|---|---|---|---|---|---|---|---|---|---|---|---|---|
| STEP | | 1 | 2 | 3 | 4 | 5 | 6 | 7 | 8 | 9 | 10 | 11 | 12 | 13 | ... |
| TIME (sec) | | 1.5 | 1.5 | 1.5 | 1.5 | 1.5 | 1.5 | 1.5 | 1.5 | 1.5 | 1.5 | 1.5 | 1.5 | 1.5 | ... |
| $WF_6$ | | PRE-FLOW | PRE-FLOW | FLOW | | PRE-FLOW | PRE-FLOW | FLOW | | PRE-FLOW | PRE-FLOW | FLOW | | PRE-FLOW | |
| $SiH_4$ | | | | PRE-FLOW | PRE-FLOW | FLOW | | PRE-FLOW | PRE-FLOW | FLOW | | PRE-FLOW | PRE-FLOW | FLOW | |
| $WF_6$ SWITCHING VALVE | X1 | O | O | O | O | × | × | O | O | × | × | O | O | × | |
| | X2 | O | O | × | × | O | O | × | × | O | O | × | × | O | |
| | X3 | × | × | O | × | × | × | O | × | × | × | O | × | × | |
| $SiH_4$ SWITCHING VALVE | Y1 | O | O | × | × | O | O | × | × | O | O | × | × | O | |
| | Y2 | × | × | O | O | × | × | O | O | × | × | O | O | × | |
| | Y3 | × | × | × | × | O | × | × | × | O | × | × | × | O | |
| $WF_6$ | VESSEL 22 | | | ▨ | | | | ▨ | | | | ▨ | | | |
| | BY-PASS PIPE 64 | ▨ | ▨ | | | ▨ | ▨ | | | ▨ | ▨ | | | ▨ | |
| | PUMP 44, 46 | ▨ | ▨ | ▨ | | ▨ | ▨ | ▨ | | ▨ | ▨ | ▨ | | ▨ | |
| $SiH_4$ | VESSEL 22 | | | | | ▨ | | | | ▨ | | | | ▨ | |
| | BY-PASS PIPE 68 | | | ▨ | ▨ | | | ▨ | ▨ | | | ▨ | ▨ | | |
| | PUMP 44, 46 | | | | | ▨ | ▨ | | | ▨ | ▨ | | | ▨ | ▨ |

O ··· OPEN  × ··· CLOSE  ▨ ··· GAS FLOW

## FIG. 3

FIG. 4

# FIG. 5

| | | | | FIRST CYCLE | | | | SECOND CYCLE | | | | THIRD CYCLE | | | |
|---|---|---|---|---|---|---|---|---|---|---|---|---|---|---|---|
| STEP | | 1 | 2 | 3 | 4 | 5 | 6 | 7 | 8 | 9 | 10 | 11 | 12 | 13 | ... |
| TIME (sec) | | 1.5 | 1.5 | 1.5 | 1.5 | 1.5 | 1.5 | 1.5 | 1.5 | 1.5 | 1.5 | 1.5 | 1.5 | 1.5 | ... |
| $WF_6$ | | PRE-FLOW | PRE-FLOW | FLOW | | PRE-FLOW | PRE-FLOW | FLOW | | PRE-FLOW | PRE-FLOW | FLOW | | PRE-FLOW | |
| $SiH_4$ | | | | PRE-FLOW | PRE-FLOW | FLOW | | PRE-FLOW | PRE-FLOW | FLOW | | PRE-FLOW | PRE-FLOW | FLOW | |
| $WF_6$ SWITCHING VALVE | X1 | O | O | × | × | O | O | × | × | O | O | × | × | O | |
| | X2 | × | × | O | × | × | × | O | × | × | × | O | × | × | |
| $SiH_4$ SWITCHING VALVE | Y1 | × | × | O | O | × | × | O | O | × | × | O | O | × | |
| | Y2 | × | × | × | × | O | × | × | × | O | × | × | × | O | |
| $WF_6$ — VESSEL 22 | | | | ▨ | | | | ▨ | | | | ▨ | | | |
| $WF_6$ — BY-PASS PIPE 64 | | ▨ | ▨ | | | ▨ | ▨ | | | ▨ | ▨ | | | ▨ | |
| $WF_6$ — PUMP 44, 46 | | ▨ | ▨ | ▨ | | ▨ | ▨ | ▨ | | ▨ | ▨ | ▨ | | ▨ | |
| $SiH_4$ — VESSEL 22 | | | | | | ▨ | | | | ▨ | | | | ▨ | |
| $SiH_4$ — BY-PASS PIPE 68 | | | | ▨ | ▨ | | | ▨ | ▨ | | | ▨ | ▨ | | |
| $SiH_4$ — PUMP 44, 46 | | | | ▨ | ▨ | ▨ | | ▨ | ▨ | ▨ | | ▨ | ▨ | ▨ | |

DEPOSITION IN PUMP (under steps 3–4, 5–6, 7–8, 9–10, 11–12, 13)

O ··· OPEN   × ··· CLOSE   ▨ ··· GAS FLOW

EP 1 643 004 B1

F I G. 6

FIG.7

EP 1 643 004 B1

ZrCℓ$_4$    O$_3$    ↙ $\underline{10}$

$\underline{8}$ →    MFC    MFC

V2 ⌇    V3 ⌇

V1 ⌇    ⌇    ⌇    ⌇ V4

W

$\underline{2}$

14

12

P — 4

← $\underline{6}$

SCRUBBER — 5

EVACUATION

# FIG. 8

P1

ZrCℓ$_4$    O$_3$    ZrCℓ$_4$    O$_3$    ZrCℓ$_4$    .........

PRE-
FLOW    PRE-
FLOW    PRE-
FLOW

PRE-
FLOW    PRE-
FLOW

# FIG. 9

FIG. 10

**EP 1 643 004 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002256440 A

- JP 2002151489 A